# EUROPEAN PATENT SPECIFICATION

(11) **EP 3 188 232 B1**
(45) Date of publication and mention of the grant of the patent: **28.11.2018**
(21) Application number: 15836567.6
(22) Date of filing: 20.05.2015
(51) Int. Cl.: H01L 25/07, H01G 2/08, H01G 2/10, H01G 4/224, H01L 23/40, H01L 23/473, H01L 25/18

(54) **POWER SEMICONDUCTOR DEVICE AND POWER SEMICONDUCTOR DEVICE PRODUCTION METHOD**
LEISTUNGSHALBLEITERBAUELEMENT UND VORRICHTUNG ZUR HERSTELLUNG EINES LEISTUNGSHALBLEITERBAUELEMENTS
DISPOSITIF À SEMICONDUCTEURS DE PUISSANCE ET PROCÉDÉ DE PRODUCTION D'UN DISPOSITIF À SEMICONDUCTEURS DE PUISSANCE

(30) Priority: 27.08.2014 JP 2014172167
(43) Date of publication of application: 05.07.2017
(73) Proprietor: Hitachi, Ltd., Tokyo 100-8280 (JP)
(72) Inventor: KUSUKAWA, Junpei, Tokyo 100-8280 (JP); NAKATSU, Kinya, Tokyo 100-8280 (JP); IDE, Eiichi, Tokyo 100-8280 (JP); OONISHI, Masami, Tokyo 100-8280 (JP)
(74) Representative: Strehl Schübel-Hopf & Partner
(86) International application number: PCT/JP2015/064397
(87) International publication number: WO 2016/031317

(56) References cited:
- EP-A1- 2 426 715
- WO-A1-2013/094028
- WO-A1-2013/094028
- JP-A- 2001 320 005
- JP-A- 2001 320 005
- JP-A- 2001 352 023
- JP-A- 2005 237 141
- JP-A- 2005 237 141
- JP-A- 2010 119 299
- JP-A- 2010 258 315
- JP-A- 2011 223 753
- JP-A- 2014 116 400

## Description

### TECHNICAL FIELD

The present invention relates to a power semiconductor device (module) and a power semiconductor module production method. More particularly, the present invention relates to a power semiconductor module preferably used in a power converter apparatus, such as an inverter, and a production method of the power semiconductor module.

### BACKGROUND ART

In recent years, environmental and resource problems at a global level have come to attract public attention. For effective utilization of resources, promotion of energy saving, and decrease of global warming gas emission, power converter apparatuses, such as inverter, have increasingly been used in a wide variety of equipment including home electrical appliances, industrial equipment, vehicles such as hybrid vehicles (HEV), railroads, electric power, or social-infrastructure-related equipment.

As many countries in the world become more sensitive to environment and energy saving, demands for such power converters are firmly growing. In particular, a rapid increase of the power converters is expected in the field of renewable energy, such as solar power generation or wind power generation, in response to a global trend of abandonment of nuclear power after the Great East Japan Earthquake in March 2011.

The power converters are needed to achieve low cost, small installation space, and high reliability.

A power converter includes many component parts, such as a power semiconductor module having an internal power semiconductor element such as an IGBT, bus bars, coils, capacitors for smoothing a direct current power, and a control circuit.

For the low cost, small, and reliable power converter, a technology for achieving a small and highly reliable power semiconductor module as a main component part of the power converter is crucial.

A structure and a production process of the power semiconductor module that have been used heretofore are described below.

An insulating substrate (ceramic insulating plate) is formed by sintering materials, such as aluminum oxide (Al₂O₃), aluminum nitride (AlN), or silicon nitride (SiN). A conductor plate, such as copper foil, is adhered to both sides of the insulating substrate via a brazing material to form a circuit electrode and a back electrode by, for example, etching. An insulating substrate having the circuit electrode is thus obtained. Subsequently, the circuit electrode and the back electrode may be subjected to plating, as needed, such as nickel plating.

A solder paste is applied on the circuit electrode of the insulating substrate, on which a power semiconductor element is mounted to bond the circuit electrode to the power semiconductor element by reflow soldering. The element electrode and the circuit electrode of the insulating substrate are connected by wire using aluminum thin wires. After that, a heat dissipation metal base plate and the back electrode of the insulating substrate are bonded together by, for example, soldering. The circuit electrode of the insulating substrate and the metal terminals are then bonded together, a resin case is disposed around the heat dissipating metal base plate, and finally the power semiconductor element is subjected to insulation sealing with a resin material such as silicone gel and a liquid epoxy resin to complete the power semiconductor module.

The power semiconductor element switches an electric current of from several amperes to several hundred amperes, causing heat generation of the element. Heat dissipation of the generated heat greatly affects the miniaturization and reliability of the module. In the past structure of the power semiconductor module, the generated heat is dissipated from one side of the power semiconductor element. Accordingly, a heat dissipation characteristic is low, and a limited miniaturization and reliability are achieved in the power semiconductor module.

Therefore, a power semiconductor module developed recently includes an electrode, an insulating substrate, and a heat dissipation plate on both sides of the power semiconductor element. This structure (both sides cooling structure) allows dissipation of heat generated in the power semiconductor element from both sides of the element.

In one example of such a technique, JP 2010-010504 A (Patent Literature 1) discloses a technique to cover and seal a power semiconductor element, a first insulating substrate (ceramic substrate) and a second insulating substrate (ceramic substrate) with resin. As a result of this, one surface of the power semiconductor element is connected to a metal pattern of one side of the first insulating substrate, and the other surface of the power semiconductor element is connected to a metal pattern of one side of the second insulating substrate, so as to expose the metal pattern of the other side of the first insulating substrate and the metal pattern of the other side of the second insulating substrate.

In another example, JP 2007-311441 A (Patent Literature 2) discloses a technique to provide a heat dissipation unit having a refrigerant channel to flow the refrigerant therethrough on both sides of a power semiconductor sealed body. In another example, WO 2009/125779 A (Patent Literature 3) discloses a technique to provide a heat dissipation unit on both sides of the power semiconductor sealed body, and layering a plurality of power semiconductor sealed bodies across the heat dissipation unit.

### CITATION LIST

### PATENT LITERATURES

PATENT LITERATURE 1: JP 2010-010504 A
PATENT LITERATURE 2: JP 2007-311441 A
PATENT LITERATURE 3: WO 2009/125779 A

### SUMMARY OF INVENTION

### TECHNICAL PROBLEM

The power semiconductor module, when used as the power converter such as an inverter, includes smoothing capacitors disposed in parallel with the power semiconductor module to decrease a ripple voltage that occurs during switching of the power semiconductor element, thereby forming a main circuit of the power converter. To decrease a surge voltage and the ripple voltage, it is effective that inductance between the power semiconductor module and the smoothing capacotors is deacresed as much as possible. Thus, it has been desired to provide a semiconductor module including an internal capacitor.

Although the techniques disclosed in Patent Literatures 1 to 3 recite the techniques to dissipate heat generated in the power semiconductor element from both sides of the element by providing the heat dissipation unit on both sides of the power semiconductor sealed body, the provision of the internal capacitor has not been considered.

In particular, in the power semiconductor module that provides a high electric current of from several tens of amperes to several hundreds of amperes, when a film capacitor is used as a smoothing capacitor, such a film capacitor is typically formed by vapor deposition of metal, such as aluminum, on an organic film made of, for example, polypropylene, to form and wind a metallized film. The organic film, however, is easily affected by heat and expands with heat to change the characteristic of the organic film. Thus, the cooling of the capacitor is also needed.

In the past technique, therefore, the power semiconductor module that allows, for example, several hundreds of amperes have an insufficient cooling ability of the capacitor, which inevitably leads to the increase in size of the power semiconductor module.

It is an object of the present invention to provide a power semiconductor module having a high heat dissipation ability of both of a power semiconductor element and a film capacitor, being small, and having high reliability, and a production method of such a power semiconductor module.

JP 2005 237141 A discloses a power semiconductor module with the features in the preamble of present claim 1. Other conventional modules are described in JP 2001 320005 A, WO 2013/094028 A1 and EP 2 426 715 A1.

### SOLUTION TO PROBLEM

To achieve the above object, the present invention is configured as defined in present claims 1 and 7. The dependent claims relate to preferred embodiments. The present disclosure relates to a partitioning wall member having an opening on one side and an opening on the other side, a semiconductor and a film capacitor housed in the opening on the one side, a cooler housed in the opening on the other side, and a sealing material sealed in the opening on the one side, the semiconductor element and the film capacitor being individually housed between the coolers via the partitioning wall member.

Alternatively, the semiconductor and the film capacitor are configured to be housed in the opening on the one side of the partitioning wall member, and the cooler is configured to be housed in the opening on the other side of the partitioning wall member, the semiconductor element and the film capacitor being individually housed between the coolers via the partitioning wall member, and the opening on the one side being sealed with a sealing material.

In a specific example, a power semiconductor module includes a power semiconductor sealed body including a power semiconductor element having a first main surface and a second main surface, a first heat dissipation plate disposed on the first main surface of the power semiconductor element via a bonding material to dissipate heat of the semiconductor element, and a second heat dissipation plate disposed on the second main surface of the power semiconductor element via the bonding material to dissipate heat of the power semiconductor element, in which at least the power semiconductor element, a bonding surface of the first heat dissipation plate bonded to the power semiconductor element, and a bonding surface of the second heat dissipation plate bonded to the power semiconductor element are sealed with an insulating resin. The power semiconductor module also includes a film capacitor, a cooler, and a partitioning wall member (thin plate case) for housing the power semiconductor sealed body, the film capacitor, and the cooler. In the power semiconductor module, the partitioning wall member has a plurality of upper and lower openings, such that the power semiconductor sealed body and the film capacitor are individually housed in each of the opening of the partitioning wall member having an upper opening, the cooler is housed in each of the openings having a lower opening, and the power semiconductor sealed body and the film capacitor are disposed across the cooler.

### ADVANTAGEOUS EFFECTS OF INVENTION

According to the present invention, a power semiconductor module having a high heat dissipation ability of both of a power semiconductor element and a film capacitor, being small, and having high reliability can be achieved.

### BRIEF DESCRIPTION OF DRAWINGS

[FIG. 1] FIG. 1 is a structural view of a structure (both sides cooling structure) of a power semiconductor device (power semiconductor sealed body) that dissipates heat from both sides of a developed element to improve a cooling ability of the power semiconductor element.
[FIG. 2] FIG. 2 illustrates a structure of a typical film capacitor.
[FIG. 3] FIG. 3 is a structural view for explaining a power semiconductor module including an internal capacitor according to an embodiment of the present invention.
[FIG. 4] FIG. 4 is a structural view for explaining the power semiconductor module including the internal capacitor according to an embodiment of the present invention.
[FIG. 5] FIG. 5 is a structural view for explaining the power semiconductor module including the internal capacitor according to an embodiment of the present invention.
[FIG. 6] FIG. 6 is a view for explaining a circuit configuration of the power semiconductor module including the internal capacitor according to the present invention.

### DESCRIPTION OF EMBODIMENTS

Embodiments of the present invention will be described below by referring to the accompanying drawings.

### FIRST EMBODIMENT

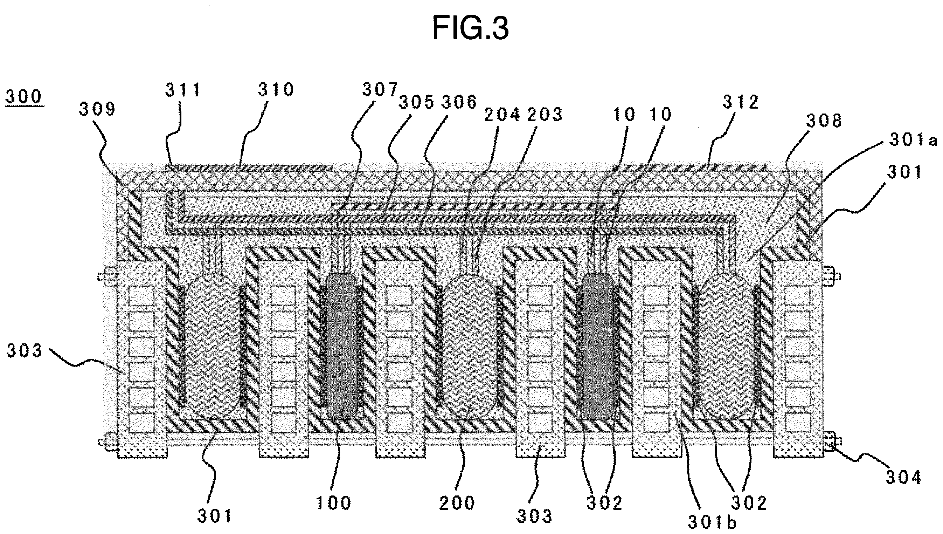

FIG. 3 illustrates cross-sectional structure of a power semiconductor module including an internal capacitor according to a first embodiment as an embodiment of the present invention.

The power semiconductor module of the first embodiment was manufactured as follows.

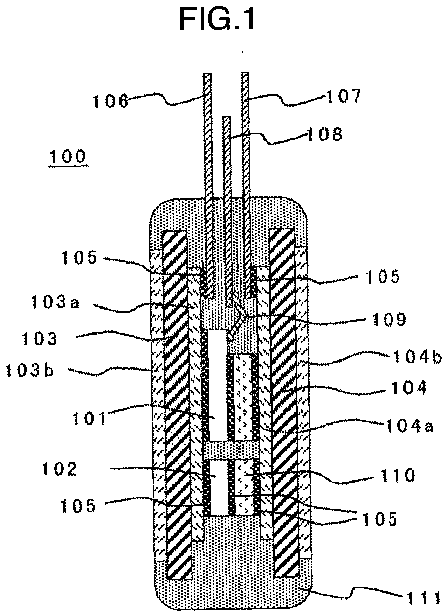

First, production of a power semiconductor sealed body 100 (or may also simply be referred to as a semiconductor) is described by referring to FIG. 1. Two insulating circuit substrates, each including a circuit electrode on one side of an insulating substrate formed by sintering silicon nitride (SiN), and a back electrode for heat dissipation on the opposite side of the insulating substrate, were prepared. (A first insulating substrate is represented by a first insulating substrate 103, a second insulating substrate is represented by a second insulating substrate 104, a circuit electrode of each of the insulating substrates is represented by a circuit electrode 103a, 104a, respectively, and a back electrode of each of the insulating substrates is represented by a back electrode 103b, 104b, respectively.) On a solder 105 formed at a predetermined position of the circuit electrode 103a of the first insulating substrate 103, a collector lead 106, a gate lead 108, and a power semiconductor element 101 (101: power semiconductor element (IGBT), 102: power semiconductor element (diode). The power semiconductor element (IGBT) 101 is representatively described below and the description of the power semiconductor element (diode) 102 is omitted, but the power semiconductor element (diode) 102 is configured similarly.) were disposed with its collector electrode overlapped at a position of a circuit electrode 103a, and a first insulating substrate, the power semiconductor element, a collector lead 106, and a gate lead 108 were bonded together by reflow soldering. A metal wire 109 (aluminum wire) was used to connect the gate electrode of the power semiconductor element 101 to a circuit portion of the circuit electrode 103a to which the gate lead 108 was connected. Then, on a solder 105 formed at a predetermined position of the circuit electrode 104a of the second insulating substrate 104, an emitter lead 107 and a spacer 110 were mounted and bonded together by reflow soldering. The solder 105 was then formed on a spacer to align the spacer with the emitter electrode of the power semiconductor element 101, such that the circuit electrode of the first insulating substrate 103 and the circuit electrode of the second insulating substrate 104 face each other and were bonded together by solder bonding through a reflow furnace. These components were then disposed in a die for transfer molding, and a sealing resin 111 (epoxy molding resin) was formed for insulation sealing of the entire power semiconductor element 101, which was located between the first and second insulating substrates, at a predetermined temperature and pressure for predetermined time period to form the power semiconductor sealed body 100.

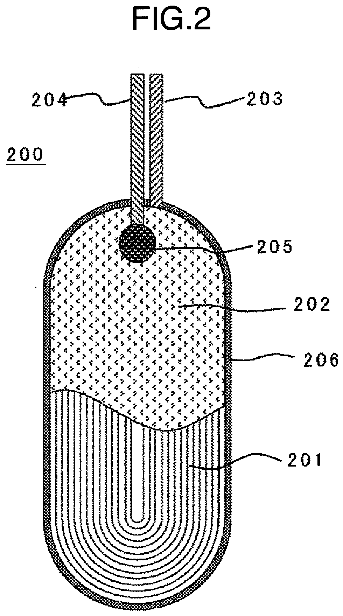

Next, a film capacitor 200 illustrated in FIG. 2 was formed as follows. First, an aluminum thin film electrode was formed on one side of a polypropylene film by a continuous vacuum vapor deposition apparatus, while a metallized film was formed and two metallized films were then wound together to form a wound metallized film 201. Subsequently, a current collecting electrode 202, which is called a metallicon electrode, was formed on both end surfaces of the wound metallized film by aluminum metal spraying, and a positive electrode side lead and a negative electrode side lead were then bonded individually to the current collecting electrode using the solder 205. Finally, an exterior covering material 206 was formed with epoxy powder resin to cover the entire metallized film and the current collecting electrode, such that the film capacitor was completed.

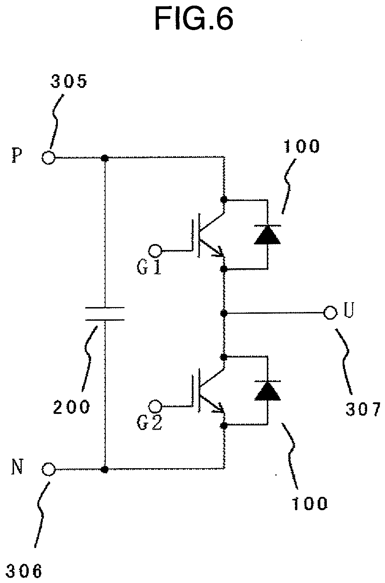

A circuit structure using the power semiconductor sealed body 100 is described by referring to FIG. 6. The power semiconductor sealed body 100 (upper arm) and the power semiconductor sealed body 100 (lower arm) are connected in series. One side of the series-connected power semiconductor sealed body 100 forms a direct current terminal P. The other side of the series-connected power semiconductor sealed body 100 forms a direct current terminal N. A connection point between the power semiconductor sealed body 100 (upper arm) and the power semiconductor sealed body 100 (lower arm) forms an alternate current terminal U. Film capacitors 200 (i.e., three film capacitors 200) are connected between the direct current terminal P and the direct current terminal N. An on-and-off signal is supplied to a gate G1 of the power semiconductor sealed body 100 (upper arm), and an on-and-off signal is supplied to a gate G2 of the power semiconductor sealed body 100 (lower arm), performing power conversion between the direct current terminals P and N and the alternate current terminal U.

Lastly, a production method of the entire power semiconductor module including the internal capacitors illustrated in FIG. 3 is described as a structure to achieve the circuit structure. First, an aluminum thin plate was press-formed to provide a partitioning wall member 301 to be a case of the power semiconductor sealed body 100, the film capacitor 200, and a cooler 303. A plurality of upper openings 301a and a plurality of lower openings 301b (the openings as used herein refer not only to entrance portions of the openings but also including groove internal portions) are formed by press forming. A heat dissipation buffer member 302 made of carbon was provided on both sides of the back electrode 103b of the first insulating substrate and the back electrode 104b of the second insulating substrate, which were exposed on both sides of the power semiconductor sealed body 100, and the power semiconductor sealed body and the heat dissipation buffer member were inserted into the upper opening 301a. Similarly, both sides of the film capacitor were also inserted into another upper opening 301a while the heat dissipation buffer member 302 is provided on both sides of them. If the number of openings of the partitioning wall member, the number of power semiconductor sealed bodies, and the number of film capacitors are selected freely, a power semiconductor module having a predetermined capacity (e.g., 1,200 A or 1,800 A) can be provided. Next, the cooler was inserted in the lower opening 301b of the partitioning wall member 301, and the partitioning wall member, the power semiconductor sealed body, the film capacitor, and the cooler were fixed by a fastening member 304. An N bus bar 306, a P bus bar 305, and an output bus bar 307 were disposed above the upper openings of the partitioning wall member, and each bus bar was bonded to a collector lead and an emitter lead of the power semiconductor sealed body and the positive electrode side lead and the negative electrode side lead of the film capacitor by welding. A sealing resin (silicone gel) was poured into the upper openings of the partitioning wall member to bury all bus bars, and cured at a predetermined temperature for a predetermined time period. An upper lid 309 was then attached, and the bus bars were finally bent to form a P terminal 310, an N terminal 311, and an output terminal 312. (Although a gate terminal is also necessary for operating the power semiconductor element, the gate terminal is not illustrated in FIG. 3 to prevent complication of illustration.)

According to the present embodiment, as described above, the power semiconductor sealed body having the heat dissipation plates provided on both sides of the power semiconductor element and the film capacitor are disposed across the cooler, allowing cooling of the heat generated in the power semiconductor element from both sides of the power semiconductor element. The film capacitor is also disposed apart from the power semiconductor sealed body across the cooler and not easily affected by the heat generated in the power semiconductor element. The heat generated in the film capacitor can be cooled from both sides of the film capacitor. If a curved portion or a bent portion that allows expansion and contraction is provided at a part of the partitioning wall member that houses the film capacitor, the film capacitor capable of expansion and contraction according to a change of temperature can fix stress applied between the film capacitor and the partitioning wall member to be constant, thus preventing damage caused by compression to the film capacitor or breakage of the partitioning wall. Meanwhile, the film capacitor provided inside the power semiconductor module can decrease the length of the wiring of the power semiconductor element and the film capacitor, reduce inductance, and suppress surge voltage at the time of switching of the power semiconductor element. Further, the power semiconductor sealed body and the film capacitor are inserted into the upper opening of the partitioning wall member, and electrically bonded by the bus bars formed. After that, the insulating resin is made to fill the entire upper opening to allow insulation between the leads of the semiconductor sealed body and the film capacitor, and the bus bars. Thus, the power semiconductor module including the internal capacitor, being small and high-density, and having a highly reliability can be provided.

### SECOND EMBODIMENT

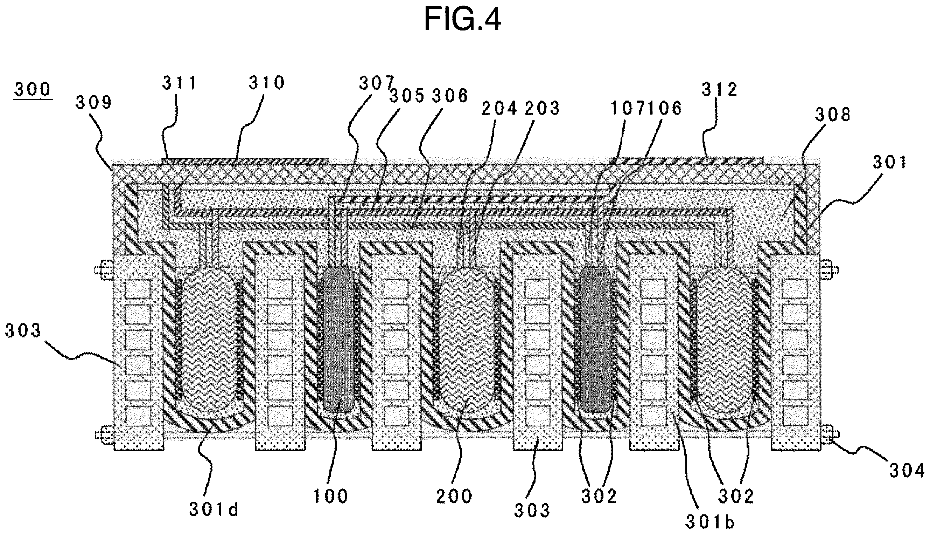

FIG. 4 illustrates a cross-sectional structure of a power semiconductor module including an internal capacitor according to a second embodiment as an embodiment of the present invention. This embodiment is substantially similar to the first embodiment illustrated in FIG. 3, but the shape of the partitioning wall member (thin plate case) is different.
Specifically, a curved portion is formed on the bottom face at a part of the partitioning wall member into which the power semiconductor sealed body and the film capacitor are inserted. Organic substances, such as the sealing resin of the power semiconductor sealed body or the film of the film capacitor, have a larger coefficient of thermal expansion than that of inorganic substances, causing expansion by heat generation. The curved portion was provided to decrease stress during the expansion.

### THIRD EMBODIMENT

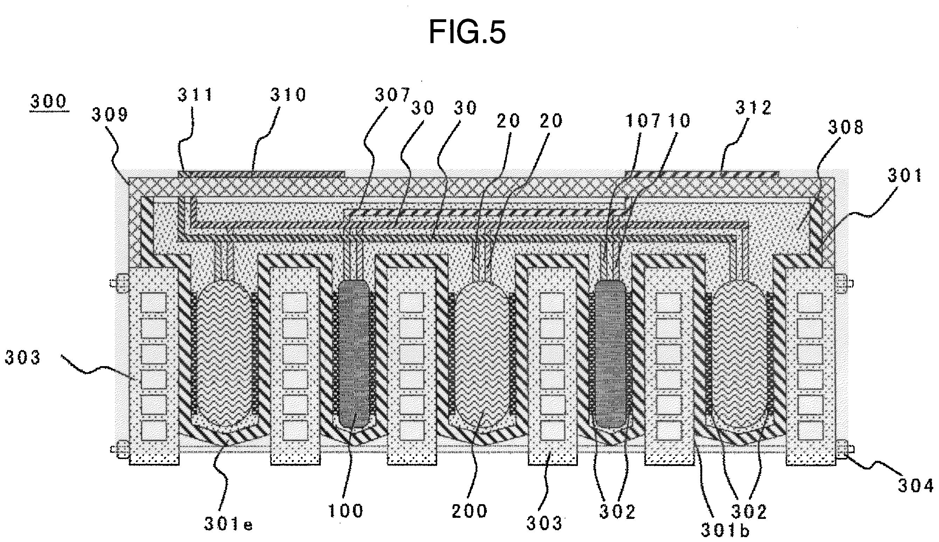

FIG. 5 illustrates a cross-sectional structure of a power semiconductor module including an internal capacitor according to a third embodiment as an embodiment of the present invention. This embodiment is substantially similar to the first embodiment illustrated in FIG. 3, but the shape of the partitioning wall member (thin plate case) is different. Specifically, a bent portion is formed on the bottom face at a part of the partitioning wall member into which the power semiconductor sealed body and the film capacitor are inserted. Organic substances, such as the sealing resin of the power semiconductor sealed body or the film of the film capacitor, have a larger coefficient of thermal expansion than that of inorganic substances, causing expansion by heat generation. The bent portion was provided to decrease stress during the expansion.

### REFERENCE SIGNS LIST

- 100: Power semiconductor sealed body
- 101: Power semiconductor element (IGBT)
- 102: Power semiconductor element (diode)
- 103: First insulating substrate
- 103a: Circuit electrode of first insulating substrate
- 103b: Back electrode of first insulating substrate
- 104: Second insulating substrate
- 104a: Circuit electrode of second insulating substrate
- 104b: Back electrode of second insulating substrate
- 105: Bonding material (solder)
- 106: Collector lead
- 107: Emitter lead
- 108: Gate lead
- 109: Metal wire
- 110: Spacer
- 111: Sealing resin
- 200: Film capacitor
- 201: Wound metallized film
- 202: Current collecting electrode
- 203: Positive electrode side lead
- 204: Negative electrode side lead
- 205: Bonding material (solder)
- 206: Exterior covering material
- 300: Power semiconductor module with internal capacitor
- 301: Partitioning wall member (thin plate case)
- 301a: Upper opening of partitioning wall member
- 301b: Lower opening of partitioning wall member
- 302: Heat dissipation buffer member
- 303: Cooler
- 304: Fastening member
- 305: P-bus bar (positive electrode side bus bar)
- 306: N-bus bar (negative electrode side bus bar)
- 307: Output bus bar
- 308: Sealing resin (e.g., silicone gel)
- 309: Upper lid, 310: P-terminal (positive electrode terminal)
- 311: N-terminal (negative electrode terminal)
- 312: Output terminal

## Claims

1. A power semiconductor module, comprising:
a partitioning wall member (301) having a plurality of openings (301a) on one side and a plurality of openings (301b) on the other side of the partitioning wall member (301);
a semiconductor (100) and a film capacitor (200);
a plurality of bus bars (305-307) each bonded to a collector lead (106) and an emitter lead (107) of the semiconductor (100) and to a positive electrode side lead (203) and a negative electrode side lead (204) of the film capacitor (200);
a plurality of coolers (303) housed in the openings (301b) on the other side; and
a sealing material (308) sealed in the openings (301a) on the one side,
**characterised in that**
the semiconductor (100) and the film capacitor (200) are housed alternately in the openings (301a) on the one side,
each of the semiconductor (100) and the film capacitor (200) is individually housed between two of the plurality of coolers (303) to allow dissipation of heat, and
the sealing material (308) buries the semiconductor (100), the film capacitor (200) and the plurality of the bus bars (305-307).

2. The power semiconductor module according to claim 1, wherein the semiconductor (100) includes
a first main surface,
a second main surface,
a first heat dissipation plate disposed on the first main surface and dissipating heat via a bonding material (205), and
a second heat dissipation plate disposed on the second main surface and dissipating heat via a bonding material (205), the heat from the first heat dissipation plate is cooled by the cooler (303) on the one side of the opening (301a), and the heat from the second heat dissipation plate is cooled by the cooler (303) on the other side of the opening (301a).

3. The power semiconductor module according to claim 1, wherein a bent portion (301e) or a curved portion (301d) allowing extraction and contraction is formed at least at a part of the partitioning wall member (301) in which the film capacitor (200) is housed.

4. The power semiconductor module according to any one of claims 1 to 3, wherein the sealing material (308) is a resin that insulates a semiconductor lead (106-108), a film capacitor lead (203, 204), and the bus bars (305-307) from each other and is made to fill the openings (301a) on the one side of the partitioning wall member (301).

5. The power semiconductor module according to claim 1, wherein the power semiconductor module comprises a plurality of the film capacitors (200) alternately arranged with a plurality of the semiconductors (100) and connected with each other by the bus bar (305-307).

6. The power semiconductor module according to claim 1, wherein the power semiconductor module comprises a plurality of the semiconductors (100) alternately arranged with a plurality of the film capacitors (200) and connected in series in which one side and the other side of the series-connected semiconductors (100) each form a direct current terminal (P, N), and a mutual connection point forms an alternate current terminal (U).

7. A power semiconductor module production method, comprising:
disposing a semiconductor (100) and a film capacitor (200) alternately in a plurality of openings (301a) on one side of a partitioning wall member (301);
bonding a plurality of bus bars (305-307) to a collector lead (106) and an emitter lead (107) of the semiconductor (100) and to a positive electrode side lead (203) and a negative electrode side lead (204) of the film capacitor (200);
disposing a plurality of coolers (303) in a plurality of openings (301b) on the other side of the partitioning wall member (301), wherein each of the semiconductor (100) and the film capacitor (200) is individually housed between two of the plurality of coolers (303) to allow dissipation of heat; and
sealing the opening (301a) on the one side with a sealing material (308) which buries the semiconductor (100), the film capacitor (200) and the plurality of the bus bars (305-307).

## Patentansprüche

1. Leistungshalbleitermodul mit
einem Trennwandelement (301), das mehrere Öffnungen (301a) auf einer Seite und mehrere Öffnungen (301b) auf der anderen Seite des Trennwandelements (301) aufweist,
einem Halbleiter (100) und einem Filmkondensator (200),
mehreren Stromschienen (305-307), die jeweils mit einer Kollektorleitung (106) und einer Emitterleitung (107) des Halbleiters (100) und mit einer Positivelektrodenseiten-Leitung (203) und einer Negativelektrodenseiten-Leitung (204) des Filmkondensators (200) verbunden sind,
mehreren in den Öffnungen (301b) auf der anderen Seite untergebrachten Kühlern (303), und
einem in den Öffnungen (301a) auf der einen Seite abgedichteten Dichtungsmaterial (308),
**dadurch gekennzeichnet, dass**
der Halbleiter (100) und der Filmkondensator (200) abwechselnd in den Öffnungen (301a) auf der einen Seite untergebracht sind,
sowohl der Halbleiter (100) als auch der Filmkondensator (200) einzeln zwischen zweien der mehreren Kühler (303) untergebracht sind, um eine Ableitung von Wärme zu erlauben, und
das Dichtungsmaterial (308) den Halbleiter (100), den Filmkondensator (200) und die mehreren Stromschienen (305-307) einbettet.

2. Leistungshalbleitermodul nach Anspruch 1, wobei der Halbleiter (100) aufweist:
eine erste Hauptfläche,
eine zweite Hauptfläche,
eine erste Wärmeableitungsplatte, die auf der ersten Hauptfläche angeordnet ist und Wärme über ein Verbindungsmaterial (205) ableitet, und
eine zweite Wärmeableitungsplatte, die auf der zweiten Hauptfläche angeordnet ist und Wärme über ein Verbindungsmaterial (205) ableitet, wobei die Wärme von der ersten Wärmeableitungsplatte durch den Kühler (303) auf der einen Seite der Öffnung (301a) gekühlt wird, und die Wärme von der zweiten Wärmeableitungsplatte durch den Kühler (303) auf der anderen Seite der Öffnung (301a) gekühlt wird.

3. Leistungshalbleitermodul nach Anspruch 1, wobei ein gebogener Abschnitt (301e) oder ein gekrümmter Abschnitt (301d), die Expansion und Kontraktion erlauben, wenigstens an einem Teil des Trennwandelements (301) gebildet ist, in dem der Filmkondensator (200) untergebracht ist.

4. Leistungshalbleitermodul nach einem der Ansprüche 1 bis 3, wobei das Dichtungsmaterial (308) ein Harz ist, das eine Halbleiterleitung (106-108), eine Filmkondensatorleitung (203, 204) und die Stromschienen (305-307) voneinander isoliert und das dazu gebracht wird, die Öffnungen (301a) auf der einen Seite des Trennwandelements (301) auszufüllen.

5. Leistungshalbleitermodul nach Anspruch 1, wobei das Leistungshalbleitermodul mehrere Filmkondensatoren (200) aufweist, die abwechselnd mit mehreren der Halbleiter (100) angeordnet und durch die Stromschienen (305-307) aneinander angeschlossen sind.

6. Leistungshalbleitermodul nach Anspruch 1, wobei das Leistungshalbleitermodul mehrere der Halbleiter (100) aufweist, die abwechselnd mit mehreren der Filmkondensatoren (200) angeordnet und in Serie angeschlossen sind, wobei eine Seite und die andere Seite der in Serie angeschlossenen Halbleiter (100) jeweils einen Gleichstromanschluss (P, N) bilden, und ein gemeinsamer Anschlusspunkt einen Wechselstromanschluss (U) bildet.

7. Leistungshalbleitermodul-Herstellungsverfahren, in dem
ein Halbleiter (100) und ein Filmkondensator (200) abwechselnd in mehreren Öffnungen (301a) auf einer Seite eines Trennwandelements (301) angeordnet werden,
mehrere Stromschienen (305-307) mit einer Kollektorleitung (106) und einer Emitterleitung (107) des Halbleiters (100) und mit einer Positivelektrodenseiten-Leitung (203) und einer Negativelektrodenseiten-Leitung (204) des Filmkondensators (200) verbunden werden,
mehrere Kühler (303) in mehreren Öffnungen (301b) auf der anderen Seite des Trennwandelements (301) angeordnet werden, wobei sowohl der Halbleiter (100) als auch der Filmkondensator (200) einzeln zwischen zweien der mehreren Kühler (303) untergebracht ist, um ein Ableiten von Wärme zu erlauben, und
die Öffnung (301a) auf der einen Seite mit einem Dichtungsmaterial (308) abgedichtet wird, in das der Halbleiter (100), der Filmkondensator (200) und die mehreren Stromschienen (305-307) eingebettet sind.

## Revendications

1. Module à semi-conducteurs de puissance, comprenant :
un élément (301) de paroi de cloisonnement ayant une pluralité d'ouvertures (301a) sur un côté et une pluralité d'ouvertures (301b) sur l'autre côté de l'élément (301) de paroi de cloisonnement ;
un semi-conducteur (100) et un condensateur à film (200) ;
une pluralité de barres omnibus (305-307) liées chacune à un conducteur (106) de collecteur et un conducteur (107) d'émetteur du semi-conducteur (100) et à un conducteur (203) de côté électrode positive et un conducteur (204) de côté électrode négative du condensateur à film (200) ;
une pluralité de refroidisseurs (303) logés dans les ouvertures (301b) sur l'autre côté ; et
une matière de scellage (308) scellée dans les ouvertures (301a) sur le côté,
**caractérisé en ce que**
le semi-conducteur (100) et le condensateur à film (200) sont logés de manière alternée dans les ouvertures (301a) sur le côté,
chacun du semi-conducteur (100) et du condensateur à film (200) est individuellement logé entre deux de la pluralité de refroidisseurs (303) pour permettre une dissipation de chaleur, et
la matière de scellage (308) noie le semi-conducteur (100), le condensateur à film (200) et la pluralité de barres omnibus (305-307).

2. Module à semi-conducteurs de puissance selon la revendication 1, dans lequel le semi-conducteur (100) inclut
une première surface principale,
une deuxième surface principale,
une première plaque de dissipation de chaleur disposée sur la première surface principale et dissipant la chaleur par l'intermédiaire d'une matière de liaison (205), et
une deuxième plaque de dissipation de chaleur disposée sur la deuxième surface principale et dissipant la chaleur par l'intermédiaire d'une matière de liaison (205), la chaleur provenant de la première plaque de dissipation de chaleur est refroidie par le refroidisseur (303) sur le côté de l'ouverture (301a), et la chaleur provenant de la deuxième plaque de dissipation de chaleur est refroidie par le refroidisseur (303) sur l'autre côté de l'ouverture (301a).

3. Module à semi-conducteurs de puissance selon la revendication 1, dans lequel une partie pliée (301e) ou une partie incurvée (301d) permettant une extraction et une contraction est formée au moins au niveau d'une partie de l'élément (301) de paroi de cloisonnement dans laquelle le condensateur à film (200) est logé.

4. Module à semi-conducteurs de puissance selon l'une quelconque des revendications 1 à 3, dans lequel la matière de scellage (308) est une résine qui isole un conducteur (106-108) de semi-conducteur, un conducteur (203, 204) de condensateur à film, et les barres omnibus (305-307) les uns des autres et est prévue pour remplir les ouvertures (301a) sur le côté de l'élément (301) de paroi de cloisonnement.

5. Module à semi-conducteurs de puissance selon la revendication 1, dans lequel le module à semi-conducteurs de puissance comprend une pluralité de condensateurs à film (200) agencés de manière alternée avec une pluralité des semi-conducteurs (100) et connectés les uns avec les autres par la barre omnibus (305-307).

6. Module à semi-conducteurs de puissance selon la revendication 1, dans lequel le module à semi-conducteurs de puissance comprend une pluralité des semi-conducteurs (100) agencés de manière alternée avec une pluralité de condensateurs à film (200) et connectés en série dans lequel un côté et l'autre côté des semi-conducteurs (100) connectés en série forment chacun une borne de courant continu (P, N), et un point de connexion mutuelle forme une borne de courant alternatif (U).

7. Procédé de production de module à semi-conducteurs de puissance, comprenant :
la mise en place d'un semi-conducteur (100) et d'un condensateur à film (200) de manière alternée dans une pluralité d'ouvertures (301a) sur un côté d'un élément (301) de paroi de cloisonnement ;
la liaison d'une pluralité de barres omnibus (305-307) à un conducteur (106) de collecteur et un conducteur (107) d'émetteur du semi-conducteur (100) et à un conducteur (203) de côté électrode positive et un conducteur (204) de côté électrode négative du condensateur à film (200) ;
la mise en place d'une pluralité de refroidisseurs (303) dans une pluralité d'ouvertures (301b) sur l'autre côté de l'élément (301) de paroi de cloisonnement, dans lequel chacun du semi-conducteur (100) et du condensateur à film (200) est individuellement logé entre deux de la pluralité de refroidisseurs (303) pour permettre une dissipation de chaleur, et
le scellage de l'ouverture (301a) sur le côté avec une matière de scellage (308) qui noie le semi-conducteur (100), le condensateur à film (200) et la pluralité de barres omnibus (305-307).
